# EUROPEAN PATENT APPLICATION

(11) **EP 4 658 044 A1**
(43) Date of publication of application: **03.12.2025**
(21) Application number: 23959247.0
(22) Date of filing: 24.11.2023
(51) Int. Cl.: H10K 59/124

(54) **DISPLAY SUBSTRATE AND MANUFACTURING METHOD THEREFOR, AND DISPLAY DEVICE**

(71) Applicant: Boe Technology Group Co., Ltd., Beijing 100015 (CN); Chengdu BOE Optoelectronics Technology Co., Ltd., Chengdu, Sichuan 611731 (CN)
(72) Inventor: HOU, Peng, Beijing 100176 (CN); LUO, Lihui, Beijing 100176 (CN); MA, Dezhao, Beijing 100176 (CN)
(74) Representative: Brötz, Helmut
(86) International application number: PCT/CN2023/133887
(87) International publication number: WO 2025/107276

(57) **Abstract**

A display substrate and a manufacturing method therefor, and a display device. The display substrate comprises a base substrate, a plurality of sub-pixels, an insulating layer and a first isolation structure. Each sub-pixel comprises a light-emitting functional layer, and a first electrode and a second electrode which are located on two sides of the light-emitting functional layer in a direction perpendicular to the base substrate. The insulating layer is located between the first electrode and the base substrate, and the first isolation structure is located on a side of the insulating layer away from the base substrate. A groove in the insulating layer and the first isolation structure are at least partially located between adjacent sub-pixels, and the first isolation structure protrudes into an opening of the groove to form a first protruding portion. At least part of the first electrode and at least part of the first isolation structure are made of the same material and are arranged on the same layer, and a gap is provided between the first electrode and the first isolation structure. At least one of a plurality of film layers of the light-emitting functional layer is disconnected at the first protruding portion. By providing the first electrode and the first isolation structure, the number of process steps can be reduced, thereby simplifying the manufacturing process.

## Description

### TECHNICAL FIELD

At least one embodiment of the present disclosure relates to a display substrate, a manufacturing method thereof, and a display device.

### BACKGROUND

A tandem (tandem) organic light emitting display device consists of a plurality of light emitting units connected in series, to reduce signal crosstalk by isolating a light emitting layer between adjacent sub-pixels, to meet the performance requirement of high brightness and low power consumption of a display device.

### SUMMARY

At least one embodiment of the present disclosure provides a display substrate, a manufacturing method thereof and a display device.

At least one embodiment of the present disclosure provides a display substrate, including a base substrate; a plurality of sub-pixels, located on the base substrate, each sub-pixel in at least part of the plurality of sub-pixels includes a light emitting functional layer and a first electrode and a second electrode that are located on two sides of the light emitting functional layer along a direction perpendicular to the base substrate, the first electrode is located between the light emitting functional layer and the base substrate; the light emitting functional layer includes a plurality of film layers; and an insulating layer, located between the first electrode and the base substrate; The display substrate further includes a first isolation structure, located on a side of the insulating layer that is away from the base substrate, and an orthographic projection of the first isolation structure on the base substrate overlaps with an orthographic projection of the insulating layer on the base substrate; the insulating layer includes a groove, the groove and the first isolation structure are at least partially located between adjacent sub-pixels, a projection of the first isolation structure on the base substrate overlaps with a projection of a part, which forms an edge of the groove, of a surface of the insulating layer away from the base substrate on the base substrate, and the first isolation structure protrudes into a groove opening of the groove to form a first protrusion; at least part of the first electrode and at least part of the first isolation structure are made of a same material and are arranged in a same layer, and there is a gap between the first electrode and the first isolation structure; and at least one film layer among the plurality of film layers is disconnected at the first protrusion.

For example, according to at least one embodiment of the present disclosure, the display substrate further including a second isolation structure, stacked with the first isolation structure; a projection of the second isolation structure on the base substrate overlaps with the projection of the part of the edge of the groove on the base substrate, and the second isolation structure protrudes into the groove opening to form a second protrusion; and the second protrusion overlaps with the first protrusion in the direction perpendicular to the base substrate.

For example, according to at least one embodiment of the present disclosure, a minimum size of the second isolation structure along an arrangement direction of the adjacent sub-pixels is not greater than a minimum size of the first isolation structure along the arrangement direction of the adjacent sub-pixels.

For example, according to at least one embodiment of the present disclosure, a size of the second isolation structure in the direction perpendicular to the base substrate is 10 angstroms to 2000 angstroms.

For example, according to at least one embodiment of the present disclosure, the second isolation structure includes at least one selected from the group consisting of a conductive material and an insulation material.

For example, according to at least one embodiment of the present disclosure, the first electrode includes a plurality of electrode layers, the second isolation structure is made of the same material as at least one of the electrode layers of the first electrode, and the second isolation structure is located between the first isolation structure and the insulating layer.

For example, according to at least one embodiment of the present disclosure, the second isolation structure includes at least one film layer.

For example, according to at least one embodiment of the present disclosure, a minimum distance between the first electrode and the first isolation structure in an arrangement direction of the adjacent sub-pixels is not less than 1 micron, and a ratio of the minimum distance to a size of the sub-pixels in the arrangement direction of the adjacent sub-pixels is not greater than 2.

For example, according to at least one embodiment of the present disclosure, a ratio of a size of the first electrode in the direction perpendicular to the base substrate to a size of the first isolation structure in the direction perpendicular to the base substrate is 0.9 to 1.1.

For example, according to at least one embodiment of the present disclosure, in an arrangement direction of the adjacent sub-pixels, a ratio of a minimum size of the first protrusion to a minimum size of the first isolation structure is 0.005 to 0.2.

For example, according to at least one embodiment of the present disclosure, the groove includes a first side wall and a second side wall that are disposed opposite to each other in an arrangement direction of the adjacent sub-pixels, and in the direction perpendicular to the base substrate, at least the first side wall overlaps with the first isolation structure; a slope angle between the first side wall and a plane parallel to a contact surface of the first side wall and the first isolation structure is a first slope angle; a slope angle between the second side wall and the plane parallel to the contact surface of the first side wall and the first isolation structure is a second slope angle; and the first slope angle is not greater than the second slope angle.

For example, according to at least one embodiment of the present disclosure, the first slope angle is less than the second slope angle, and an angle of the first slope angle is 60° to 150°.

For example, according to at least one embodiment of the present disclosure, the display substrate further including a pixel defining pattern, located on a side of the first electrode that is away from the base substrate, the pixel defining pattern includes a plurality of first openings, one sub-pixel corresponds to at least one first opening, and the light emitting functional layer of the sub-pixel is at least partially located in the first opening corresponding to the sub-pixel, and the first opening is configured to expose the first electrode; the pixel defining pattern further includes a plurality of second openings, and the first protrusion is exposed by the second opening.

For example, according to at least one embodiment of the present disclosure, the pixel defining pattern includes a pixel defining portion surrounding the plurality of first openings and the plurality of second openings, and a slope angle between at least part of a side surface of the pixel defining portion and a plane parallel to a contact surface of the pixel defining portion and the first isolation structure is a third slope angle; the third slope angle is not greater than the first slope angle.

For example, according to at least one embodiment of the present disclosure, a ratio of a minimum size of the second opening along the arrangement direction of the adjacent sub-pixels to a minimum size of the first opening along the arrangement direction of the adjacent sub-pixels is 0.05 to 2.

For example, according to at least one embodiment of the present disclosure, the pixel defining portion covers the gap.

For example, according to at least one embodiment of the present disclosure, there is an overlapping portion between an orthographic projection of the pixel defining portion on the base substrate and an orthographic projection of the first electrode on the base substrate; and a minimum size of the overlapping portion along the arrangement direction of the adjacent sub-pixels is not less than 0.5 microns.

For example, according to at least one embodiment of the present disclosure, a ratio of a size of the groove opening along the arrangement direction of the adjacent sub-pixels to a size of the second opening along the arrangement direction of the adjacent sub-pixels is 0.7 to 1.5.

For example, according to at least one embodiment of the present disclosure, in the direction perpendicular to the base substrate, a maximum size of the groove is not greater than a maximum size of the insulating layer, and a size of the groove in the direction perpendicular to the base substrate is not less than 0.1 micron.

At least one embodiment of the present disclosure provides a display device, including the display substrate as mentioned above.

At least one embodiment of the present disclosure provides a manufacturing method of a display substrate, which includes: forming a plurality of sub-pixels on a base substrate, wherein forming the sub-pixels includes sequentially forming a first electrode, a light emitting functional layer, and a second electrode that are stacked in a direction perpendicular to the base substrate, and the first electrode is located between the light emitting functional layer and the base substrate; and the manufacturing method further includes: forming an insulation material layer on the base substrate; and forming a conductive material layer on a side of the insulation material layer that is away from the base substrate, wherein the conductive material layer is patterned to form the first electrode and an isolation structure, and there is a gap between the first electrode and the isolation structure; etching the insulation material layer to form a groove, wherein a projection of the isolation structure on the base substrate overlaps with a projection of a part, which forms an edge of the groove, of a surface of the insulating layer away from the base substrate on the base substrate, and the isolation structure protrudes into a groove opening of the groove to form a protrusion; and the light emitting functional layer is formed after the groove is formed, the light emitting functional layer includes a plurality of film layers, and at least one film layer among the plurality of film layers is disconnected at the protrusion.

### BRIEF DESCRIPTION OF DRAWINGS

In order to clearly illustrate the technical solution of the embodiments of the invention, the drawings of the embodiments will be briefly described in the following; it is obvious that the described drawings are only related to some embodiments of the present disclosure and thus are not limitative of the present disclosure.
Fig. 1 is a partial cross-sectional schematic view of a display substrate;
Fig. 2A is a partial cross-sectional schematic view of another display substrate;
Fig. 2B is a partial structural electron microscope view of still another display substrate;
Fig. 3A is a partial planar schematic view of a display substrate provided by an example in at least one embodiment of the present disclosure;
Fig. 3B and Fig. 3C are partial cross-sectional schematic diagrams truncated by line AA' shown in Fig. 3A;
Fig. 3D is a partial cross-sectional schematic view of a first electrode and a first isolation structure in a display substrate shown in Fig. 3B;
Fig. 4A is a partial planar schematic view of a display substrate provided by an example in at least one embodiment of the present disclosure;
Fig. 4B is a partial cross-sectional schematic view truncated by line BB' shown in Fig. 4A;
Fig. 5A to Fig. 5E are schematic flowcharts of a manufacturing method of a display substrate before the formation of the structure shown in Fig. 3B provided by an example in at least one embodiment of the present disclosure;
Fig. 6A and Fig. 6B are schematic flowcharts of a manufacturing method of a display substrate before the formation of the structure shown in Fig. 3B provided by another example in at least one embodiment of the present disclosure;
Fig. 7A is a partial planar schematic view of a display substrate provided by an example in at least one embodiment of the present disclosure;
Fig. 7B is a partial cross-sectional schematic diagram truncated by line CC' shown in Fig. 7A;
Fig. 8A and Fig. 8B are schematic flowcharts of a manufacturing method of a display substrate before the formation of the structure shown in Fig. 7B provided by an example in at least one embodiment of the present disclosure; and
Fig. 9 is a partial cross-sectional schematic view of a display substrate provided by an example in at least one embodiment of the present disclosure.

### DETAILED DESCRIPTION

In order to make objects, technical details and advantages of the embodiments of the disclosure apparent, the technical solutions of the embodiments will be described in a clearly and fully understandable way in connection with the drawings related to the embodiments of the disclosure. Apparently, the described embodiments are just a part but not all of the embodiments of the disclosure. Based on the described embodiments herein, those skilled in the art can obtain other embodiment(s), without any inventive work, which should be within the scope of the disclosure.

Unless otherwise defined, all the technical and scientific terms used herein have the same meanings as commonly understood by one of ordinary skill in the art to which the present disclosure belongs. The terms "first," "second," etc., which are used in the description and the claims of the present disclosure, are not intended to indicate any sequence, amount or importance, but distinguish various components. The terms "comprise," "comprising," "include," "including," etc., are intended to specify that the elements or the objects stated before these terms encompass the elements or the objects and equivalents thereof listed after these terms, but do not preclude the other elements or objects.

In the embodiment of the present disclosure, the features, "perpendicular to," "parallel to," "identical to," etc., all include the features "perpendicular to," "parallel to," "identical to," etc., in the strict sense, as well as the cases containing certain errors, such as "approximately perpendicular to," "approximately parallel to," "approximately identical to," etc. Considering the measurement and the errors related to the measurement of a specific quantity (e.g., the limitation of the measurement system), they are within an acceptable deviation range for the specific quantity determined by those skilled in the art. For example, the "center" in the embodiment of the present disclosure can include a strictly geometric center position and a roughly central position in a small area around the geometric center. For example, the term "approximately" can mean within one or more standard deviations, or within 10% or 5% deviation of the stated value.

In a tandem organic light emitting diode (TOLED), a plurality of independent light emitting units are connected in series, current of a same magnitude flows through a plurality of different light emitting units successively, causing multiple different light emitting units to emit light together, thereby improving illuminous brightness and efficiency. In the case of a same current density, the illuminous brightness and current efficiency of the TOLED device are far higher than those of an organic light emitting diode (OLED) device, and the TOLED device has the advantages such as high brightness, low current density, high current efficiency and long life, and has a good development prospect and practical value in the field of solid-state semiconductor light emission.

In studies, the inventors of the present application have noticed that: a light emitting functional layer of a sub-pixel may include a plurality of light emitting layers stacked; a charge generation layer (CGL) is disposed between at least two of the plurality of light emitting layers and has great electric conductivity; when the charge generation layer is a film layer covering an entire surface, the charge generation layers of two adjacent sub-pixels are of a continuous film layer, and transverse conduction of charge may occur. For example, at a light emitting phase of a sub-pixel (e.g., a green sub-pixel), charge transportation by the charge generation layers may cause a neighboring red sub-pixel or blue sub-pixel or green sub-pixel ought not to emit light to be lightened, forming a color deviation.

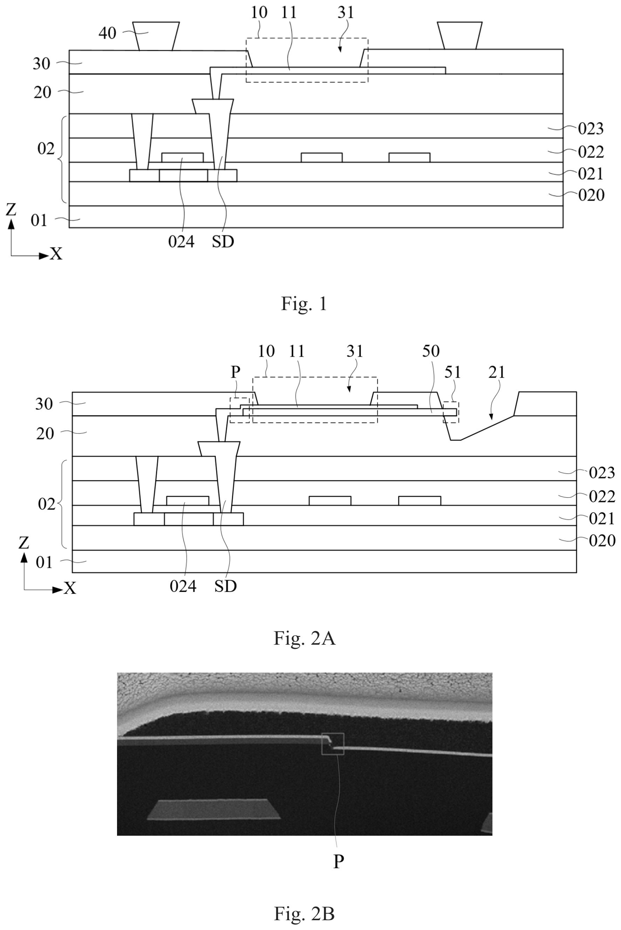

Fig. 1 is a partial cross-sectional schematic view of a display substrate.

As shown in Fig. 1, the display substrate includes a base substrate 01, a plurality of sub-pixels 10, a pixel defining pattern 30, and spacers 40. The plurality of sub-pixels 10 are located on the base substrate 01, and each sub-pixel 10 in at least part of the plurality of sub-pixels 10 includes a light emitting functional layer (not shown in Fig. 1) and a first electrode 11 and a second electrode (not shown in Fig. 1) that are located on two sides of the light emitting functional layer along a direction (for example, the Z direction shown in Fig. 1) perpendicular to the base substrate 01. The first electrode 11 is located between the light emitting functional layer and the base substrate 01, and the light emitting functional layer includes a plurality of film layers. The pixel defining pattern 30 is located on a side of the first electrode 11 that is away from the base substrate 01, and the pixel defining pattern 30 includes a plurality of first openings 31, one sub-pixel 10 corresponds to at least one first opening 31, and the light emitting element of the sub-pixel 10 is at least partially located in the first opening 31 corresponding to the sub-pixel 10, and the first opening 31 is configured to expose the first electrode 11. The spacers 40 are located on a side of the pixel defining pattern 30 that is away from the base substrate 01, and the spacers 40 are spacers 40 with undercut (undercut) structures. Through the spacers 40 with the undercut structures, at least one film layer among the plurality of film layers included in the light emitting functional layer can be disconnected at the spacers 40.

In studies, the inventors of the present application have noticed that: the spacers 40 have the undercut structures, and sizes (thicknesses) of the spacers 40 in the direction perpendicular to the base substrate 01 are relatively large, and therefore relatively large steps are formed. In some subsequent processes, for example, a color filter on encapsulation (Color Filter on Encapsulation, COE) process or an enhanced efficiency structure (Enhanced Efficiency Structure, EES) process, problems such as film tear may be easily caused at a stage of module (Module, MDL). Moreover, the spacers 40 with undercut structures have relatively concentrated stress at their corners, which may cause adverse conditions such as cracking or separation of the evaporated encapsulation film layers.

Fig. 2A is a partial cross-sectional schematic view of another display substrate. Fig. 2B is a partial structural electron microscope view of still another display substrate. For example, the structure shown in the electron microscope view in Fig. 2B may be the same as some film layers or some structures in the display substrate shown in Fig. 2A.

As shown in Fig. 2A, the display substrate includes a base substrate 01, a plurality of sub-pixels 10, a pixel defining pattern 30, an insulating layer 20, and an inorganic layer 50. The plurality of sub-pixels 10 are located on the base substrate 01, and each sub-pixel 10 in at least part of the sub-pixels 10 includes a light emitting functional layer (not shown in Fig. 2A) and a first electrode 11 and a second electrode (not shown in Fig. 2A) that are located on two sides of the light emitting functional layer along a direction (the Z direction shown in Fig. 2A) perpendicular to the base substrate 01. The first electrode 11 is located between the light emitting functional layer and the base substrate 01, and the light emitting functional layer includes a plurality of film layers. The pixel defining pattern 30 is located on a side of the first electrode 11 that is away from the base substrate 01, the pixel defining pattern 30 includes a plurality of first openings 31, one sub-pixel 10 corresponds to at least one first opening 31, and the light emitting element of the sub-pixel 10 is at least partially located in the first opening 31 corresponding to the sub-pixel 10, and the first opening 31 is configured to expose the first electrode 11. The insulating layer 20 is located between the first electrode 11 and the base substrate 01, and the inorganic layer 50 is located between the first electrode 11 and the insulating layer 20. The insulating layer 20 includes a groove 21, the groove 21 and the inorganic layer 50 are at least partially located between the adjacent sub-pixels 10. A projection of the inorganic layer 50 on the base substrate 01 overlaps with a projection of a part, which forms an edge of the groove 21, of a surface of the insulating layer 20 away from the base substrate 01 on the base substrate 01, and the inorganic layer 50 protrudes into an opening of the groove 21 to form a protrusion 51. The protrusion 51 is formed at the groove 21 of the insulating layer 20 through the inorganic layer 50, so that at least one of the plurality of film layers of the light emitting functional layer can be disconnected at the protrusion 51 and the groove 21.

In studies, the inventors of the present application have noticed that: after the deposition of the inorganic layer 50 is completed, the inorganic layer 50 still needs to be patterned, such as exposing and dry etching the inorganic layer 50. When wet etching the first electrode 11, the insulating layer 20 will not be over-etched, but the inorganic layer 50 will be over-etched by using ion gas in the processes of exposure and dry etching, resulting in the formation of a large step at the adjacent part of the inorganic layer 50 and the insulating layer 20 as shown at position P in Fig. 2A. Therefore, as shown in Fig. 2A and Fig. 2B, after the first electrode 11 is deposited, the first electrode 11 may have a disconnection defect at the step (P shown in Fig. 2A and Fig. 2B), resulting in open-circuit of current.

At least one embodiment of the present disclosure provides a display substrate. The display substrate includes: a base substrate; a plurality of sub-pixels, located on the base substrate, each of at least part of the plurality of sub-pixels includes a light emitting functional layer and a first electrode and a second electrode that are located on two sides of the light emitting functional layer along a direction perpendicular to the base substrate, the first electrode is located between the light emitting functional layer and the base substrate; the light emitting functional layer includes a plurality of film layers; and an insulating layer, located between the first electrode and the base substrate, the display substrate further includes a first isolation structure, located on a side of the insulating layer that is away from the base substrate, and an orthographic projection of the first isolation structure on the base substrate overlaps with an orthographic projection of the insulating layer on the base substrate; the insulating layer includes a groove, the groove and the first isolation structure are at least partially located between adjacent sub-pixels, a projection of the first isolation structure on the base substrate overlaps with a projection of a part, which forms an edge of the groove, of a surface of the insulating layer away from the base substrate, and the first isolation structure protrudes into a groove opening of the groove, to form a first protrusion; at least part of the first electrode and at least part of the first isolation structure are made of a same material, and are arranged in a same layer, and there is a gap between the first electrode and the first isolation structure; and at least one film layer among the plurality of film layers is disconnected at the first protrusion.

At least one embodiment of the present disclosure provides a display device, including the display substrate according to any one of the above-mentioned embodiments.

At least one embodiment of the present disclosure provides a manufacturing method of a display substrate. The manufacturing method includes: forming a plurality of sub-pixels on a base substrate, forming the sub-pixels includes sequentially forming a first electrode, a light emitting functional layer, and a second electrode that are stacked in a direction perpendicular to the base substrate, and the first electrode is located between the light emitting functional layer and the base substrate; and the manufacturing method further includes: forming an insulation material layer on the base substrate; and forming a conductive material layer on a side of the insulation material layer that is away from the base substrate, the conductive material layer is patterned to form the first electrode and an isolation structure, and there is a gap between the first electrode and the isolation structure; etching the insulation material layer to form a groove, wherein a projection of the isolation structure on the base substrate overlaps with a projection of a part, which forms an edge of the groove, of a surface of the insulating layer away from the base substrate, and the isolation structure protrudes into a groove opening of the groove to form a protrusion; and the light emitting functional layer is formed after the groove is formed, the light emitting functional layer includes a plurality of film layers, and at least one film layer among the plurality of film layers is disconnected at the protrusion.

According to the display substrate and the manufacturing method thereof, and the display device provided in embodiments of the present disclosure, by setting the groove and the first isolation structure between adjacent sub-pixels in the display substrate, at least one film layer of the light emitting functional layer can be disconnected at the first protrusion where the first isolation structure protrudes relative to the edge of the groove, which is beneficial to reducing the probability of generating crosstalk between adjacent sub-pixels. Moreover, by setting at least part of the first electrode and the first isolation structure to be made of the same material and arranged in the same layer, one process can be saved and the manufacturing process can be simplified. In addition, by setting the gap between the first electrode and the first isolation structure, it is beneficial to prevent the first isolation structure from transmitting electrical signals to the area where the sub-pixel is located.

The display substrate, the manufacturing method thereof and the display device are described below by some embodiments with reference to the accompanying drawings.

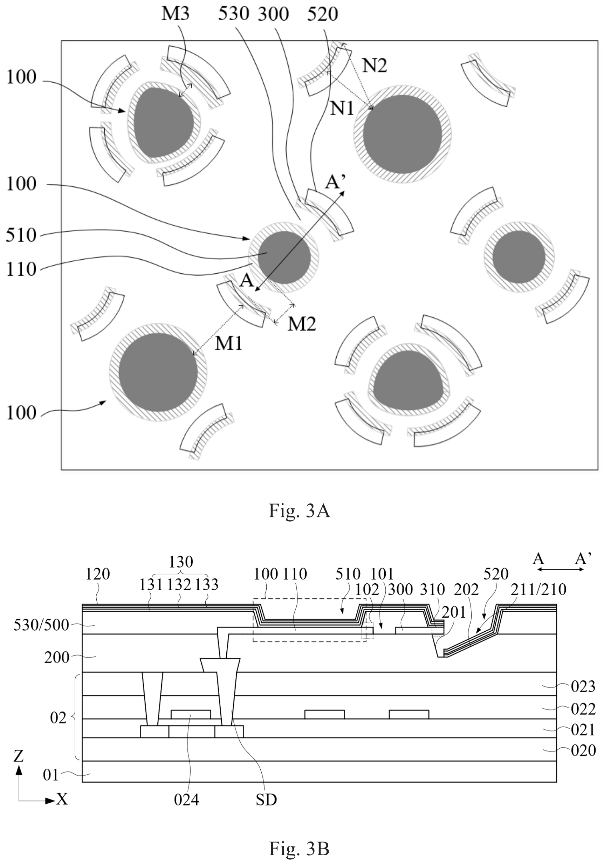

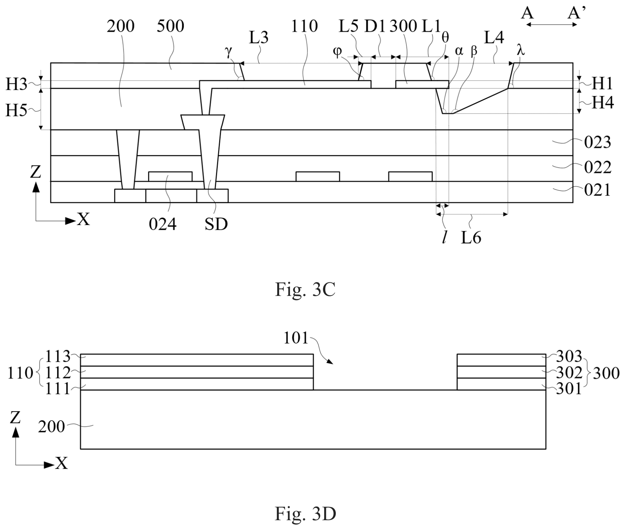

Fig. 3A is a partial planar schematic view of a display substrate provided by an example in at least one embodiment of the present disclosure. Fig. 3B and Fig. 3C are partial cross-sectional schematic diagrams truncated by line AA' shown in Fig. 3A. Fig. 3D is a partial cross-sectional schematic view of a first electrode and a first isolation structure in a display substrate shown in Fig. 3B. Fig. 3C differs from Fig. 3B in that, to mark more clearly, a light emitting functional layer 130, a second electrode 120, a base substrate 01, and some film layers in other film layers 02 in Fig. 3B are omitted in Fig. 3C. For example, the line AA' is parallel to the X direction.

At least one embodiment of the present disclosure provides a display substrate. As shown in Fig. 3A to Fig. 3D, the display substrate includes a base substrate 01, a plurality of sub-pixels 100, an insulating layer 200, and a first isolation structure 300. The plurality of sub-pixels 100 are located on the base substrate 01, and each sub-pixel 100 in at least part of the plurality of sub-pixels 100 includes the light emitting functional layer 130 and a first electrode 110 and a second electrode 120 that are located on two sides of the light emitting functional layer 130 along a direction perpendicular to the base substrate 01. For example, the direction perpendicular to the base substrate 01 is the Z direction shown in Fig. 3A. The first electrode 110 is located between the light emitting functional layer 130 and the base substrate 01, and the light emitting functional layer 130 includes a plurality of film layers. For example, the light emitting functional layer 130 includes a charge generation layer 133. For example, the light emitting element may be an organic light emitting element.

For example, the first electrode 110 may be an anode and the second electrode 120 may be a cathode. For example, the cathode may be formed of a material with high conductivity and low work function, and for example, the cathode may be made of a metallic material. For example, the anode may be formed of a transparent conductive material having a high work function.

As shown in Fig. 3B and Fig. 3C, the insulating layer 200 is located between the first electrode 110 and the base substrate 01, the first isolation structure 300 is located on a side of the insulating layer 200 that is away from the base substrate 01, and an orthographic projection of the first isolation structure 300 on the base substrate 01 overlaps with an orthographic projection of the insulating layer 200 on the base substrate 01. The insulating layer 200 includes a groove 210, and along the direction perpendicular to the base substrate 01, a thickness of the insulating layer 200 at a position other than the groove 210 is greater than a thickness of the first isolation structure 300.

As shown in Fig. 3B, the groove 210 and the first isolation structure 300 are at least partially located between the adjacent sub-pixels 100. For example, the adjacent sub-pixels 100 mean that no other sub-pixel 100 is disposed between two sub-pixels 100. A projection of the first isolation structure 300 on the base substrate 01 overlaps with a projection of a part, which forms an edge of the groove 210, of a surface of the insulating layer 200 away from the base substrate 01, and the first isolation structure 300 protrudes into a groove opening 211 of the groove 210 to form a first protrusion 310. For example, a partial structure of the first isolation structure 300 is located on the edge of the groove 210, and a partial structure of the first isolation structure 300 is located at the groove opening 211, so as to form the first protrusion 310 that covers a part of the groove opening 211.

As shown in Fig. 3B and Fig. 3D, at least part of the first electrode 110 and at least part of the first isolation structure 300 are made of a same material. The above-mentioned "at least part" may mean at least some film layers of the first electrode and/or the first isolation structure. For example, materials of the first electrode 110 and the first isolation structure 300 are completely the same. At least part of the first electrode 110 and at least part of the first isolation structure 300 are arranged in a same layer. For example, the first electrode 110 and the first isolation structure 300 are formed in a same process, so that one mask process can be saved, and there is no need to manufacture the inorganic layer 50 shown in Fig. 2A, thus simplifying the process. With reference to Fig. 3D, for example, the first electrode 110 includes a first electrode layer 111, a second electrode layer 112, and a third electrode layer 113 that are sequentially stacked on the insulating layer 200 along the Z direction. For example, the first isolation structure 300 includes a first insulating layer 301, a second insulating layer 302, and a third insulating layer 303 that are sequentially stacked on the insulating layer 200 along the Z direction. For example, the first electrode layer 111 and the first isolation layer 301 are made of the same material and are arranged in the same layer. For example, the second electrode layer 112 and the second isolation layer 302 are made of the same material and arranged in the same layer. For example, the third electrode layer 113 and the third isolation layer 303 are made of the same material and arranged in the same layer.

As shown in Fig. 3B, the first electrode 110 is formed on a flat surface of the insulating layer 200, reducing the risk of disconnection. In addition, as shown in Fig. 3B, the display substrate separates the light emitting functional layer 130 through the first isolation structure 300, and it is not necessary to form the light emitting functional layer 130 on a spacer (with reference to Fig. 1) with an undercut structure, thus reducing the risk of a film layer cracking or separation at the corners of the spacer, and also reducing the risk of film tearing caused by excessive height difference between the spacer and the insulating layer. There is a gap 101 between the first electrode 110 and the first isolation structure 300, so as to prevent electrical conduction between the first electrode 110 and the first isolation structure 300 through the gap 101, which is beneficial to prevent the first isolation structure 300 from transmitting an electrical signal to the area where the adjacent sub-pixels 100 are located.

As shown in Fig. 3B, at least one film layer among the plurality of film layers of the light emitting functional layer 130 is disconnected at the first protrusion 310. According to the embodiment of the present disclosure, the groove 210 and the first isolation structure 300 are disposed between the adjacent sub-pixels 100 in the display substrate, and by setting a relative position relationship between the first isolation structure 300 and the groove 210, at least one film layer of the light emitting functional layer 130 can be disconnected at the first protrusion 310 where the first isolation structure 300 protrudes relative to the edge of the groove 210, which is beneficial to reducing the probability of generating low-grayscale crosstalk between the adjacent sub-pixels 100.

For example, as shown in Fig. 3B, the light emitting functional layer 130 may include a first light emitting layer (EML) 131, a charge generation layer (CGL) 133, and a second light emitting layer 132 which are stacked, and the charge generation layer 133 is located between the first light emitting layer 131 and the second light emitting layer 132. The charge generation layer 133 has a high conductivity, which can make the light emitting functional layer 130 have the advantages of long life, low power consumption and achievable high brightness. For example, compared with a light emitting functional layer without the charge generation layer, the sub-pixel can nearly double the illuminous brightness by setting the charge generation layer in the light emitting functional layer.

For example, the above-mentioned sub-pixel including the charge generation layer adopts Tandem technology, N/P-CGL is used as a heterojunction, and two light emitting layers are connected in series. This technology realizes the series connection of dual light emitting devices, which greatly reduces the light emitting current of the light emitting devices and prolongs the life of the organic light emitting element under the same light emitting intensity, thus facilitating applications in new technologies with long life, such as vehicles, etc.

For example, in each sub-pixel, the light emitting functional layer can further include a hole injection layer (HIL), a hole transport layer (HTL), an electron transport layer (ETL) and an electron injection layer (EIL). For example, the hole injection layer, the hole transport layer, the electron transport layer, the electron injection layer and the charge generation layer are all common film layers for the plurality of sub-pixels, which can be called common layers. For example, at least one film layer, which is disconnected at the edge of the groove, of the light emitting functional layer can be at least one film layer of the common layers described above. By disconnecting at least one film layer of the common layers at the edge of the groove between adjacent sub-pixels, the probability of crosstalk between adjacent sub-pixels can be reduced.

As shown in Fig. 3B and Fig. 3C, in some examples, a minimum distance D1 between the first electrode 110 and the first isolation structure 300 in the arrangement direction of the adjacent sub-pixels 100 is not less than 1 micron, and a ratio of the minimum distance D1 to a size of the sub-pixels 100 in the arrangement direction of the adjacent sub-pixels 100 is not greater than 1/2. The size of the sub-pixel may be a size of a light emitting region of the sub-pixel in the arrangement direction, or may be a size of the first electrode in the sub-pixel in the arrangement direction. For example, the arrangement direction may be approximately an extension direction of the center connecting line or the nearest connecting line of the light emitting regions of adjacent sub-pixels; or if the light emitting regions of the adjacent sub-pixels 100 are distributed along the X direction, and the arrangement direction is the X direction. For example, in the X direction, the minimum distance D1 between the first electrode 110 and the first isolation structure 300 is equal to 1 micron or greater than 1 micron, so that the first electrode 110 is isolated from the first isolation structure 300, to prevent an electrical connection between the first electrode 110 and the first isolation structure 300. For example, in the X direction, a ratio of the minimum distance D1 between the first electrode 110 and the first isolation structure 300 to the size of the sub-pixel 100 is equal to 1/2 or less than 1/2.

For example, sub-pixels include a first color sub-pixel, a second color sub-pixel, and a third color sub-pixel. For example, with reference to Fig. 3A, three sub-pixels 100 respectively represent the first color sub-pixel, the second color sub-pixel, and the third color sub-pixel. For example, the first color sub-pixel emits red light, and is the red sub-pixel. For example, the second color sub-pixel emits green light, and is the green sub-pixel. For example, the third color sub-pixel emits blue light, and is the blue sub-pixel. For example, the area of a light emitting region of the green sub-pixel is the smallest, and the area of the light emitting region of the blue sub-pixel is the largest, or the area of the light emitting region of the red sub-pixel is the largest, which is not limited in embodiment of the present disclosure. For example, with reference to Fig. 3B and Fig. 3C, the size of the sub-pixel in the X direction is the largest size in the size of the first color sub-pixel, the size of the second color sub-pixel, and the size of the third color sub-pixel in the X direction.

For example, with reference to Fig. 3A and Fig. 3B, an edge of a light emitting region of at least one sub-pixel 100 may be arc-shaped, the first isolation structures 300 may be provided in a plurality, and the plurality of first isolation structures 300 are distributed at intervals in the circumferential direction of the light emitting region of the at least one sub-pixel 100. For example, a curvature of an edge of the first isolation structure 300 faces the light emitting region of the red sub-pixel may be not greater than a curvature of an edge of the light emitting region of the red sub-pixel faces the first isolation structure 300, to prevent a distance between an end part of the first isolation structure 300 and the light emitting region of the red sub-pixel from being excessively small. For example, the curvature of the edge of the first isolation structure 300 faces the light emitting region of the green sub-pixel may be not greater than the curvature of the edge of the light emitting region of the green sub-pixel faces the first isolation structure 300, to prevent a distance between an end part of the first isolation structure 300 and the light emitting region of the green sub-pixel from being excessively small. For example, curvatures of edges on two sides of the first isolation structure 300 in the X direction may be the same.

For example, with reference to Fig. 3A and Fig. 3B, in the X direction, a distance between the edge of the first isolation structure 300 and the edge of a light emitting region of at least one blue sub-pixel facing each other is a first distance M1, a distance between the edge of the first isolation structure 300 and an edge of a light emitting region of at least one green sub-pixel facing each other is a second distance M2, a distance between the edge of the first isolation structure 300 and the edge of a light emitting region of at least one red sub-pixel facing each other is a third distance M3, the first distance M1 is greater than the second distance M2, and the first distance M1 is greater than the third distance M3, thereby reducing the driving voltage of the blue sub-pixel. Certainly, embodiments of the present disclosure are not limited to the above-mentioned X direction, the shortest distance between the first isolation structure surrounding the blue sub-pixel and the edge of the light emitting region of the blue sub-pixel may be the first distance, the shortest distance between the first isolation structure surrounding the green sub-pixel and the edge of the light emitting region of the green sub-pixel may be the second distance, and the shortest distance between the first isolation structure surrounding the red sub-pixel and the edge of the light emitting region of the red sub-pixel may be the third distance.

For example, with reference to Fig. 3A and Fig. 3B, a difference between the minimum distance between the edge of the first isolation structure 300 and the edge of the light emitting region of the at least one blue sub-pixel facing each other and the maximum distance between the edge of the first isolation structure 300 and the edge of the light emitting region of the at least one blue sub-pixel facing each other is a first difference. For example, the minimum distance between the edge of the first isolation structure 300 and the edge of the light emitting region of the blue sub-pixel facing each other may be N1, the maximum distance between the edge of the first isolation structure 300 and the edge of the light emitting region of the blue sub-pixel facing each other may be N2, and the first difference is a difference between N1 and N2. For example, a difference between the minimum distance between the edge of the first isolation structure 300 and the edge of the light emitting region of the at least one green sub-pixel facing each other and the maximum distance between the edge of the first isolation structure 300 and the edge of the light emitting region of the at least one green sub-pixel facing each other is a second difference, a difference between the minimum distance between the edge of the first isolation structure 300 and the edge of the light emitting region of the at least one red sub-pixel facing each other and the maximum distance between the edge of the first isolation structure 300 and the edge of the light emitting region of the at least one red sub-pixel facing each other is a third difference, the first difference is greater than the second difference, and the first difference is greater than the third difference.

For example, the edge of the first isolation structure 300 and the edge of the light emitting region of the blue sub-pixel may be bent toward opposite directions, so as to increase the distance between the first isolation structure 300 and the blue sub-pixel. For example, the edge of the first isolation structure and the edge of the light emitting region of the blue sub-pixel may be bent toward a same direction, and the curvature of the edge of the first isolation structure is greater than the curvature of the edge of the light emitting region of the blue sub-pixel. For example, the edge of the first isolation structure 300 and the edge of the light emitting region of the green sub-pixel facing each other may be bent toward a same direction. For example, the edge of the first isolation structure 300 and the edge of the light emitting region of the red sub-pixel facing each other may be bent toward a same direction. For example, the shape of the edge of the first isolation structure 300 separately matches the shape of the edge of the light emitting region of the red sub-pixel and the shape of the edge of the light emitting region of the green sub-pixel.

For example, with reference to Fig. 3A and Fig. 3B, a ratio of an outer contour perimeter of the first isolation structure 300 to an outer contour perimeter of the light emitting region of at least one blue sub-pixel is a first ratio, a ratio of an outer contour perimeter of the first isolation structure 300 to an outer contour perimeter of the light emitting region of at least one green sub-pixel is a second ratio, a ratio of an outer contour perimeter of the first isolation structure 300 to an outer contour perimeter of the light emitting region of at least one red sub-pixel is a third ratio, the first ratio is greater than the second ratio, and the first ratio is greater than the third ratio.

As shown in Fig. 3B and Fig. 3C, in some examples, a ratio of a size H3 of the first electrode 110 in the direction perpendicular to the base substrate 01 to a size H1 of the first isolation structure 300 in the direction perpendicular to the base substrate 01 may be 0.9 to 1.1. For example, the size of the first electrode 110 in the direction perpendicular to the base substrate 01 is a thickness H3 of the first electrode 110. The size of the first electrode in the direction perpendicular to the base substrate may be an average thickness, a maximum thickness, or a minimum thickness at a position other than a connection between the first electrode and a transistor. For example, the size of the first isolation structure 300 in the direction perpendicular to the base substrate 01 is a thickness H1 of the first isolation structure 300. For example, the thickness of the first isolation structure may include an average thickness, a maximum thickness, or a minimum thickness. For example, a ratio of the thickness H3 of the first electrode 110 to the thickness H1 of the first isolation structure 300 may be 0.95 to 1.05. For example, the ratio of the thickness H3 of the first electrode 110 to the thickness H1 of the first isolation structure 300 may be 1. For example, thicknesses of the first electrode 110 and the first isolation structure 300 arranged in a same layer may be basically the same, so as to simplify the manufacturing process.

For example, a thickness H3 of the first electrode 110 may be 10 angstroms to 4000 angstroms. For example, the thickness H3 of the first electrode 110 may be 100 angstroms to 3000 angstroms. For example, the thickness H3 of the first electrode 110 may be 500 angstroms to 2000 angstroms. For example, the thickness H3 of the first electrode 110 may be 1000 angstroms to 1500 angstroms.

As shown in Fig. 3B and Fig. 3C, in some examples, in the arrangement direction of the adjacent sub-pixels 100, a ratio of a minimum size *l* of the first protrusion 310 to a minimum size L1 of the first isolation structure 300 may be 0.005 to 0.2. For example, the ratio of the minimum size *l* of the first protrusion 310 to the minimum size L1 of the first isolation structure 300 may be 0.01 to 0.15. For example, the ratio of the minimum size *l* of the first protrusion 310 to the minimum size L1 of the first isolation structure 300 may be 0.05 to 0.1. Therefore, by setting the size of the first protrusion 310, the light emitting functional layer 130 can be reliably disconnected through the first protrusion 310.

As shown in Fig. 3B and Fig. 3C, in some examples, the display substrate further includes a pixel defining pattern 500. For example, a material of the pixel defining pattern 500 may be a transparent material or a nontransparent material. For example, a color of the pixel defining pattern 500 may be black, light yellow, or transparent. For example, a material of the pixel defining pattern 500 may include at least one selected from the group consisting of polyimide, acrylic ester, and oxosilane. For example, the maximum size of the pixel defining pattern 500 in the direction perpendicular to the base substrate 01 is 0.5 microns to 3 microns. For example, the maximum size of the pixel defining pattern 500 in the direction perpendicular to the base substrate 01 is 1 micron to 2.5 microns. For example, the maximum size of the pixel defining pattern 500 in the direction perpendicular to the base substrate 01 is 1.5 micron to 2 microns.

As shown in Fig. 3B and Fig. 3C, the pixel defining pattern 500 is located on a side of the first electrode 110 that is away from the base substrate 01, where the pixel defining pattern 500 includes a plurality of first openings 510, one sub-pixel 100 corresponds to at least one first opening 510, and the light emitting element of the sub-pixel 100 is at least partially located in the first opening 510 corresponding to the sub-pixel 100, and the first opening 510 is configured to expose the first electrode 110. For example, at least part of the first electrode 110 is located between the pixel defining pattern 500 and the base substrate 01. For example, when the light emitting functional layer 130 is formed in the first opening 510 of the pixel defining pattern 500, the first electrode 110 and the second electrode 120 located at two sides of the light emitting functional layer 130 can drive the light emitting functional layer 130 in the first opening 510 of the pixel defining pattern 500 to emit light. For example, the above-mentioned light emitting region may refer to a region where the sub-pixel effectively emits light, and a shape of the light emitting region refers to a two-dimensional shape, for example, the shape of the light emitting region may be the same as the shape of the first opening of the pixel defining pattern.

As shown in Fig. 3B and Fig. 3C, the pixel defining pattern 500 further includes a plurality of second openings 520, and the first protrusion 310 is exposed by the second opening 520, so that the light emitting functional layer 130 can be disconnected through the first protrusion 310. For example, the second opening 520 can completely expose the first protrusion 310. For example, the second opening 520 can completely expose the groove 210. For example, as shown in Fig. 3B, in the X direction, a distance between the pixel defining portion 530 that does not overlap with the first protrusion 310 that is close to the second opening 520 and the first protrusion 310 is less than a size of the groove opening 211 in the X direction.

As shown in Fig. 3B and Fig. 3C, in some examples, a ratio of a minimum size L4 of the second opening 510 along the arrangement direction of the adjacent sub-pixels 100 to a minimum size L3 of the first opening 510 along the arrangement direction of the adjacent sub-pixels 100 may be 0.05 to 2. For example, along the arrangement direction of the adjacent sub-pixels 100, the ratio of the minimum size L4 of the second opening 520 to the minimum size L3 of the first opening 510 may be 0.1 to 1.5. For example, along the arrangement direction of the adjacent sub-pixels 100, the ratio of the minimum size L4 of the second opening 520 to the minimum size L3 of the first opening 510 may be 0.5 to 1. For example, in the X direction, the size of the second opening 520 may be greater than the size of the first opening 510. For example, in the X direction, the size of the second opening 520 may be equal to the size of the first opening 510. For example, in the X direction, the size of the second opening 520 may be less than the size of the first opening 510 to prevent affecting the size of the light emitting region.

As shown in Fig. 3B and Fig. 3C, in some examples, the pixel defining portion 530 covers the gap 101. For example, two sides of the pixel defining portion 530 in the X direction may be respectively lapped on the first electrode 110 and the first isolation structure 300, to prevent an electrical connection between the first electrode 110 and the first isolation structure 300.

As shown in Fig. 3B and Fig. 3C, in some examples, there is an overlapping portion 102 between an orthographic projection of the pixel defining portion 530 on the base substrate 01 and an orthographic projection of the first electrode 110 on the base substrate 01, and a minimum size L5 of the overlapping portion 102 along the arrangement direction of the adjacent sub-pixels 100 is not less than 0.5 microns. For example, the pixel defining portion 530 covers part of the first electrode 110. For example, the overlapping portion 102 refers to a part where a side of the first electrode 110 close to the first isolation structure 300 overlaps with the pixel defining portion 530. For example, the minimum size L5 of the overlapping portion 102 in the X direction is equal to 0.5 microns. For example, the minimum size L5 of the overlapping portion 102 in the X direction is greater than 0.5 microns.

As shown in Fig. 3B and Fig. 3C, in some examples, a ratio of a size L6 of the groove opening 211 along the arrangement direction of the adjacent sub-pixels 100 to a size L4 of the second opening 520 along the arrangement direction of the adjacent sub-pixels 100 may be 0.7 to 1.5. For example, along the arrangement direction of the adjacent sub-pixels 100, the ratio of the minimum size L6 of the groove opening 211 to the minimum size L4 of the second opening 520 may be 0.8 to 1.4. For example, along the arrangement direction of the adjacent sub-pixels 100, the ratio of the minimum size L6 of the groove opening 211 to the minimum size L4 of the second opening 520 may be 0.9 to 1.3. For example, along the arrangement direction of the adjacent sub-pixels 100, the ratio of the minimum size L6 of the groove opening 211 to the minimum size L4 of the second opening 520 may be 1 to 1.2. For example, along the arrangement direction of the adjacent sub-pixels 100, the ratio of the minimum size L6 of the groove opening 211 to the minimum size L4 of the second opening 520 may be 1.1.

As shown in Fig. 3B and Fig. 3C, in some examples, in the direction perpendicular to the base substrate 01, a maximum size H4 of the groove 210 is not greater than a maximum size H5 of the insulating layer 200, and the size H4 of the groove 210 in the direction perpendicular to the base substrate 01 is not less than 0.1 micron. For example, in the Z direction, the maximum size H4 of the groove 210 is a depth size of the groove 210, and the maximum size H5 of the insulating layer 200 is a maximum thickness of the insulating layer 200. For example, the depth size H4 of the groove 210 may be equal to 0.1 micron. For example, the depth size H4 of the groove 210 may be greater than 0.1 micron. For example, the groove 210 is provided in the insulating layer 200. Therefore, the maximum depth size H4 of the groove 210 does not exceed the maximum thickness H5 of the insulating layer 200. For example, the insulating layer 200 may be a plurality of film layers, and the maximum depth size H4 of the groove 210 does not exceed a sum of maximum thicknesses of the plurality of film layers.

As shown in Fig. 3B and Fig. 3C, in some examples, the groove 210 includes a first side wall 201 and a second side wall 202 that are disposed opposite to each other in the arrangement direction of the adjacent sub-pixels 100. In the direction perpendicular to the base substrate 01, at least the first side wall 201 overlaps with the first isolation structure 300. A slope angle between the first side wall 201 and a plane parallel to a contact surface of the first side wall 201 and the first isolation structure 300 is a first slope angle α. For example, a bottom wall of the groove 210 may be the plane parallel to the contact surface of the first side wall 201 and the first isolation structure 300, and the first slope angle α refers to an included angle between the first side wall 201 and the bottom wall of the groove 210. A slope angle between the second side wall 202 and the plane parallel to the contact surface of the first side wall 201 and the first isolation structure 300 is a second slope angle β. For example, the bottom wall of the groove 210 may be the plane parallel to the contact surface of the first side wall 201 and the first isolation structure 300, and the second slope angle β refers to an included angle between the second side wall 202 and the bottom wall of the groove 210. For example, the first slope angle α is not greater than the second slope angle β. For example, shapes of cross sections of the first side wall and the second side wall above-mentioned cut by the XZ plane may be a straight line, or may be a curved line. If the shape is the straight line, the slope angle may be an angle at an intersection of the straight line and the bottom wall in the cross section; or if the shape is the curved line, the slope angle may be an angle of a tangent line of the curved line at the intersection of the curved line and the bottom wall in the cross section.

For example, as shown in Fig. 3B and Fig. 3C, the first slope angle α is different from the second slope angle β. For example, in a process of etching the groove 210, because the first isolation structure 300 is located on a side of the first side wall 201 in the Z direction, the slope angle between the first side wall 201 and the bottom wall of the groove 210 is different from the slope angle between the second side wall 202 and the bottom wall of the groove 210. For example, the cross section of the groove 210, which is cut by a plane parallel to the XZ plane, can include a pattern with an opening encircled by three straight sides, wherein two straight sides that are intersected can form a right angle, an acute angle or an obtuse angle. And the cross section of the groove 210, which is cut by a plane parallel to the XZ plane, can include a pattern with an opening encircled by arc edges, along a direction indicated by the arrow of the Z direction shown in Fig. 3B, the size of the pattern along the Z direction may gradually increase. For example, as shown in Fig. 3B and Fig. 3C, both the first slope angle α and the second slope angle β are obtuse angles, the size of the groove 210 in the X direction gradually increases from the bottom wall of the groove 210 to the groove opening 211, and the maximum size of the groove 210 in the X direction is the size L6 of the groove opening 211.

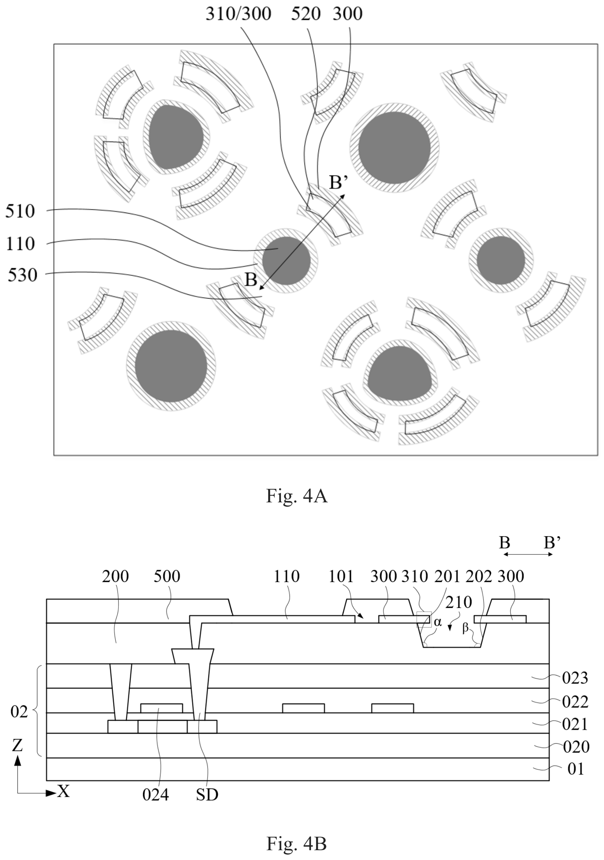

Fig. 4A is a partial planar schematic view of a display substrate provided by an example in at least one embodiment of the present disclosure. Fig. 4B is a partial cross-sectional schematic view truncated by line BB' shown in Fig. 4A. The display substrate shown in Fig. 4B differs from the display substrate shown in Fig. 3B in that quantities and positions of the first isolation structures are different. The structure other than the first isolation structure in the display substrate shown in Fig. 4B may have same features as the corresponding structure shown in Fig. 3B, and details will not be repeated here. For example, the line BB' is parallel to the X direction.

For example, as shown in Fig. 3B and Fig. 3C, the first isolation structure 300 is disposed only on a side close to the first side wall 201. In this case, because there is no blocking of the first isolation structure 300 above the second side wall 202, the first slope angle α formed after etching is less than the second slope angle β. For example, as shown in Fig. 4A and Fig. 4B, the first isolation structure 300 includes a part disposed on a side close to the first side wall 201, and a part disposed on a side close to the second side wall 202. In this case, the second slope angle β formed after etching is basically the same as the first slope angle α. For example, along the X direction, sizes of two first isolation structures 300 located on two sides of the edge of the groove 210 may be the same, and sizes by which the two first isolation structures 300 protrude into the groove 210 may be the same (that is, sizes of the two first protrusions 310 are the same). However, this application is not limited thereto. Sizes of two first isolation structures located on two sides of a same second opening and overlapping with the second opening may also be different, and sizes of the two first protrusions where the two first isolation structures extend into the second opening may be the same or may be different. Fig. 4A schematically shows that the first isolation structures are disposed on the two sides of the second opening, but this application is not limited thereto. The first isolation structure may surround at least one second opening.

With reference to Fig. 4A and Fig. 4B, by disposing the first isolation structures 300 on both the two sides of the groove 210, the isolation effect can be further improved, to prevent crosstalk generated between the adjacent sub-pixels 100 caused by the transmission of an electrical signal.

For example, the shape of the first isolation structure 300 in Fig. 4A may be the same as the shape of the first isolation structure 300 in Fig. 3A. For example, with reference to Fig. 4B, perimeters of the first isolation structures 300 located on the two sides of the groove 210 in Fig. 4A may be different. For example, taking a red sub-pixel as an example, among a plurality of first isolation structures 300 around at least one red sub-pixel, a perimeter of the first isolation structure 300 located on a side of the groove 210 that is away from the red sub-pixel may be greater than a perimeter of the first isolation structure 300 located on a side of the groove 210 that is close to the red sub-pixel. For example, taking a green sub-pixel as an example, among a plurality of first isolation structures 300 around at least one green sub-pixel, a perimeter of the first isolation structure 300 located on a side of the groove 210 that is away from the green sub-pixel may be greater than a perimeter of the first isolation structure 300 located on a side of the groove 210 that is close to the green sub-pixel. For example, taking a blue sub-pixel as an example, among a plurality of first isolation structures 300 around at least one blue sub-pixel, a perimeter of the first isolation structure 300 located on a side of the groove 210 that is close to the blue sub-pixel may be greater than a perimeter of the first isolation structure 300 located on a side of the groove 210 that is away from the blue sub-pixel.

For example, a position relationship between the first isolation structure 300 and the light emitting region of the sub-pixel 100 in Fig. 4A may be the same as a position relationship between the first isolation structure 300 and the light emitting region of the sub-pixel 100 in Fig. 3A.

As shown in Fig. 3B, Fig. 3C, Fig. 4A, and Fig. 4B, in some examples, an angle of the first slope angle α may be 60° to 150°. For example, the angle of the first slope angle α may be 75° to 135°. For example, the angle of the first slope angle α may be 90° to 120°.

As shown in Fig. 3B and Fig. 3C, in some examples, the pixel defining pattern 500 includes a pixel defining portion 530 surrounding the plurality of first openings 510 and the plurality of second openings 520, and a slope angle between at least part of a side surface of the pixel defining portion 530 and a plane parallel to a contact surface of the pixel defining portion 530 and the first isolation structure 300 is a third slope angle θ. For example, the third slope angle θ refers to an included angle between the side surface of the pixel defining portion 530 and an upper surface of the first isolation structure 300 exposed to the second opening 520.

In some examples, the third slope angle θ is not greater than the first slope angle α. For example, the first slope angle α of the groove 210 formed by etching is larger than the third slope angle θ. For example, the first slope angle α may be basically the same as the third slope angle θ. For example, the third slope angle θ is relatively smaller, so that the slope of the side wall on the side of the pixel defining portion 530 that is close to the first protrusion 310 is larger, to better expose the first protrusion 310.

As shown in Fig. 3C, for example, a slope angle between at least part of a side surface of the pixel defining portion 530 and a plane parallel to a contact surface of the pixel defining portion 530 and the first electrode 110 is a fourth slope angle γ. For example, the fourth slope angle γ refers to an included angle between the upper surface of the first electrode 110 away from the first isolation structure 300 and the pixel defining portion 530. For example, the fourth slope angle γ is an acute angle. For example, the fourth slope angle γ may be 10° to 60°. For example, the fourth slope angle γ may be 20° to 50°. For example, the fourth slope angle γ may be 30° to 45°.

As shown in Fig. 3C, for example, a ratio of an angle supplementary with the third slope angle θ to the fourth slope angle γ may be 0.5 to 1.5. For example, the ratio of the angle supplementary with the third slope angle θ to the fourth slope angle γ may be 0.7 to 1.3. For example, the ratio of the angle supplementary with the third slope angle θ to the fourth slope angle γ may be 0.9 to 1.1. For example, the angle supplementary with the third slope angle θ may be basically the same as the fourth slope angle γ.

As shown in Fig. 3C, for example, a slope angle between at least part of a side surface of the pixel defining portion 530 and a plane parallel to a contact surface of the pixel defining portion 530 and the first electrode 110 is a fifth slope angle φ. For example, the fifth slope angle φ is an included angle between the upper surface of the first electrode 110 close to the first isolation structure 300 and the pixel defining portion 530. For example, the fifth slope angle φ is an acute angle. For example, a ratio of the fifth slope angle φ to the fourth slope angle γ may be 0.5 to 1.5. For example, the ratio of the fifth slope angle φ to the fourth slope angle γ may be 0.6 to 1.4. For example, the ratio of the fifth slope angle φ to the fourth slope angle γ may be 0.8 to 1.2. For example, the ratio of the fifth slope angle φ to the fourth slope angle γ may be 0.9 to 1.1. For example, the fifth slope angle φ may be basically the same as the fourth slope angle γ.

As shown in Fig. 3C, for example, a slope angle between at least part of a side surface of the pixel defining portion 530 and a plane parallel to a contact surface of the pixel defining portion 530 and the insulating layer 200 is a sixth slope angle λ. For example, the sixth slope angle λ is an acute angle. For example, a ratio of the sixth slope angle λ to the fourth slope angle γ may be 0.5 to 1.5. For example, the ratio of the sixth slope angle λ to the fourth slope angle γ may be 0.6 to 1.4. For example, the ratio of the sixth slope angle λ to the fourth slope angle γ may be 0.8 to 1.2. For example, the ratio of the sixth slope angle λ to the fourth slope angle γ may be 0.9 to 1.1. For example, the sixth slope angle λ may be basically the same as the fourth slope angle γ.

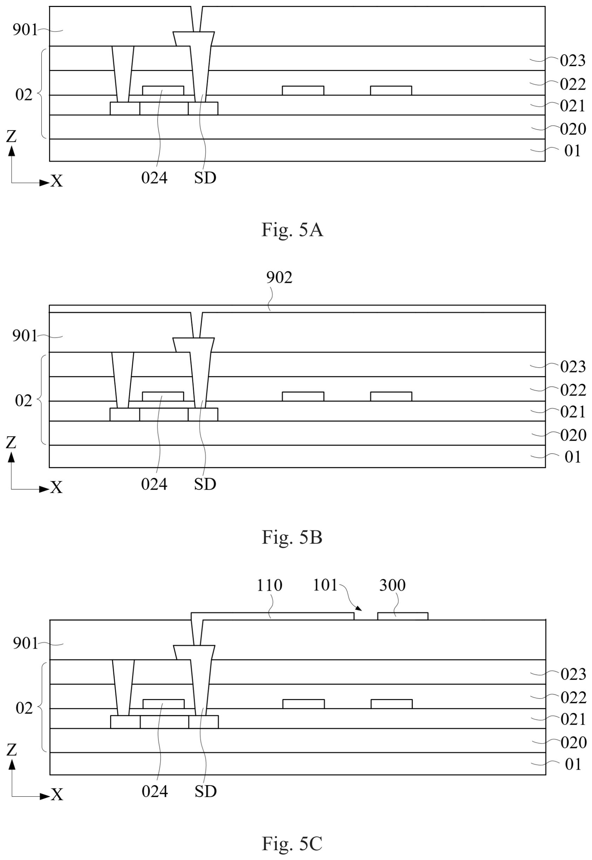

Fig. 5A to Fig. 5E are schematic flowcharts of a manufacturing method of a display substrate before the formation of the structure shown in Fig. 3B provided by an example in at least one embodiment of the present disclosure.

With reference to Fig. 5A to Fig. 5E in combination with Fig. 3B, at least one embodiment of the present disclosure provides a manufacturing method of a display substrate. The manufacturing method includes: forming a plurality of sub-pixels 100 on a base substrate 01, forming the sub-pixels 100 includes sequentially forming a first electrode 110, a light emitting functional layer 130, and a second electrode 120 that are stacked in a direction perpendicular to the base substrate 01, and the first electrode 110 is located between the light emitting functional layer 130 and the base substrate 01; as shown in Fig. 5A, forming an insulation material layer 901 on the base substrate 01; and as shown in Fig. 5B, forming a conductive material layer 902 on a side of the insulation material layer 901 that is away from the base substrate 01; for example, a material of the insulation material layer 901 may include an organic material, and the conductive material layer 902 may be an inorganic nonmetal material layer or a metal material layer. For example, the insulation material layer shown in Fig. 5A may be an insulation material layer patterned to form a via that exposes a source or a drain of a thin film transistor, but it is not limited thereto, and the insulation material layer may also refer to a film layer before being patterned. For example, the manufacturing method further includes forming other film layer 02 on the base substrate 01 before the insulation material layer 901 is formed.

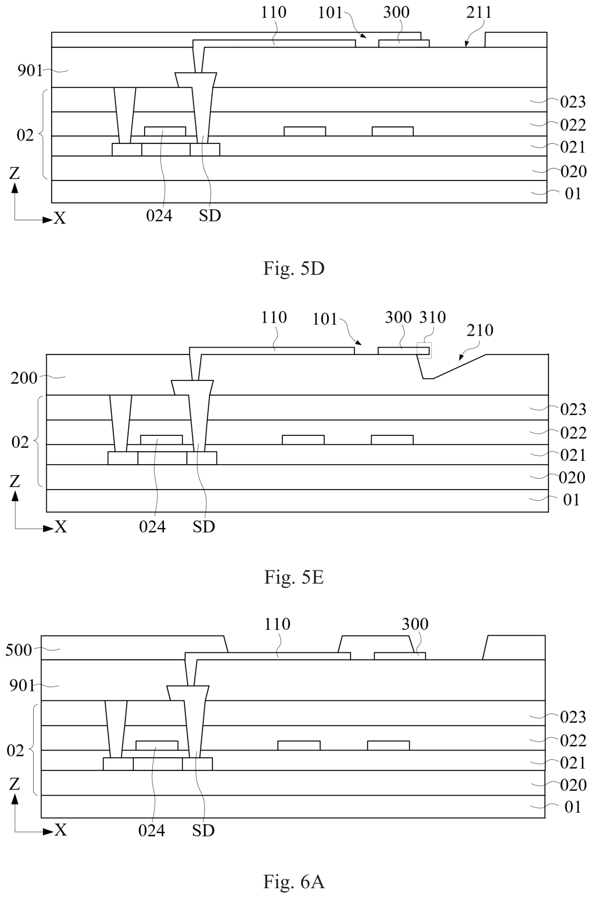

As shown in Fig. 5B and FIG 5C, the conductive material layer 902 is patterned to form the first electrode 110 and an insulation structure (that is, the first isolation structure 300), and there is a gap 101 between the first electrode 110 and the first isolation structure 300. As shown in Fig. 5D and Fig. 5E, etching the insulation material layer 901 to form a groove 210. A projection of the first isolation structure 300 on the base substrate 01 overlaps with a projection of a part, which forms an edge of the groove 210, in a surface of the insulation material layer 901 away from the base substrate 01 on the base substrate 01, and the first isolation structure 300 protrudes into a groove opening 211 to form a protrusion (that is, the first protrusion 310). The light emitting functional layer is formed after the groove 210 is formed. The light emitting functional layer includes a plurality of film layers, and at least one film layer among the plurality of film layers is disconnected at the first protrusion 310.

With reference to Fig. 5A to Fig. 5E, by patterning the conductive material layer 902, the first electrode 110 and the first isolation structure 300 can be formed at the same time in one process, thereby saving a process. For example, the conductive material layer 901 may be wet etched, to form the first electrode 110 and the first isolation structure 300. For example, in a process of wet etching the conductive material layer 901, at least one selected from the group consisting of nitric acid, phosphoric acid, acetic acid, and sulphuric acid may be used.

For example, with reference to Fig. 5C to Fig. 5E and Fig. 3B, the insulation material layer may be etched to form the groove 210 after the first electrode 110 and the first isolation structure 300 are formed and before the pixel defining pattern 500 is formed. In this way, photoresist can be relatively easily coated on a side of the first electrode 110 and the first isolation structure 300 that is away from the base substrate 01, so as to form the pixel defining pattern 500 through exposure and development. For example, a part other than the groove opening 211 may be masked to dry etch the insulating layer 200 at the groove opening 211 to form the groove 210, and the edge of the first isolation structure 300 and the edge of the groove 210 form an undercut structure. In this case, the first isolation structure 300 includes the first protrusion 310 that protrudes into the groove 210.

For example, with reference to Fig. 5D, before etching to form the groove 210, the coated photoresist needs to avoid completely covering the first isolation structure 300, so as to facilitate etching. For example, the photoresist may cover part of the upper surface of a side of the first isolation structure 300 that is away from the base substrate 01, and expose part of the upper surface. For example, the photoresist may cover the upper surface of the first isolation structure away from the base substrate, and expose a side wall of the first isolation structure in the X direction.

For example, with reference to Fig. 5D and Fig. 5E, in a process of dry etching the conductive material layer 901, at least one selected from the group consisting of oxygen, carbon tetrafluoride, chlorine, and sulphur hexafluoride may be used.

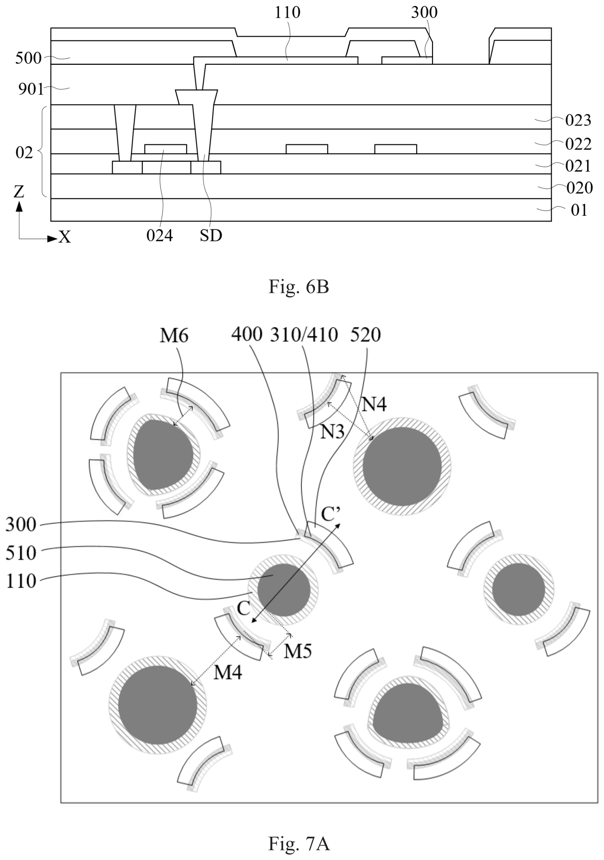

Fig. 6A and Fig. 6B are schematic flowcharts of a manufacturing method of a display substrate before the formation of the structure shown in Fig. 3B provided by another example in at least one embodiment of the present disclosure.

For example, with reference to Fig. 6A and Fig. 6B, and Fig. 3B, the pixel defining pattern 500 may be formed after the first electrode 110 and the first isolation structure 300 are formed, and after the pixel defining pattern 500 is formed, photoresist is coated on a side of the pixel defining pattern 500 that is away from the base substrate 01, and then the insulation material layer 901 is etched through exposure to form the groove 210. In this way, photoresist can be prevented from remaining in the groove 210 or below the first protrusion 310 of the first isolation structure 300 (that is, a side of the first protrusion 310 that faces the groove 210). For example, a part other than the second opening 520 may be masked to dry etch the insulating layer 200 below the second opening 520 to form the groove 210, and the edge of the first isolation structure 300 and the edge of the groove 210 form an undercut structure. In this case, the first isolation structure 300 includes the first protrusion 310 that protrudes into the groove 210.

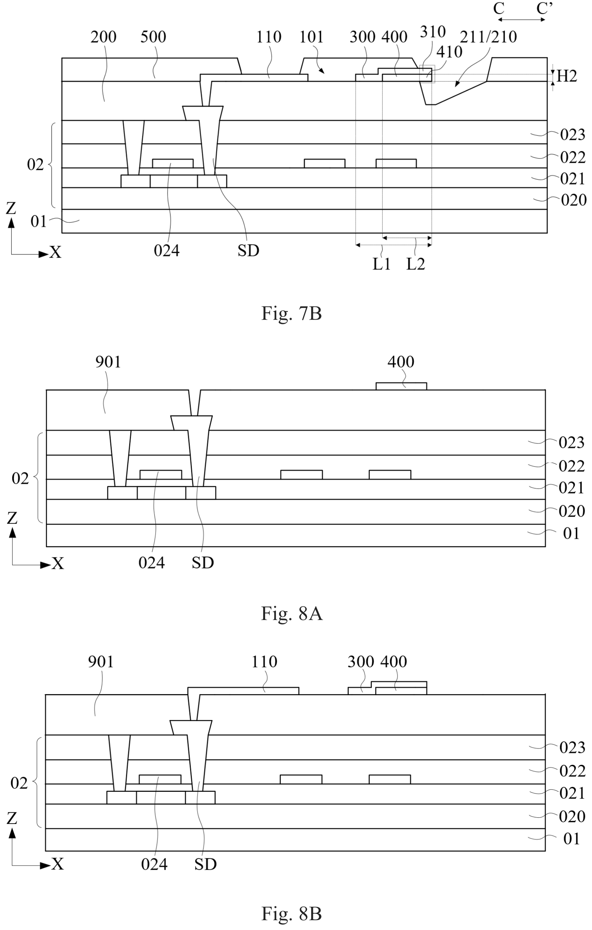

Fig. 7A is a partial planar schematic view of a display substrate provided by an example in at least one embodiment of the present disclosure. Fig. 7B is a partial cross-sectional schematic diagram truncated by line CC' shown in Fig. 7A. The display substrate shown in Fig. 7B differs from the display substrate shown in Fig. 3B in further including a second isolation structure. The structure other than the second isolation structure in the display substrate shown in Fig. 7B may have same features as the corresponding structure shown in Fig. 3B, and details will not be repeated here. For example, the second isolation structure shown in Fig. 7B may also be applied to the display substrate shown in Fig. 4B, where the second isolation structure may be disposed on one side of a same second opening, or may be disposed on two sides of a same second opening. For example, the line CC' is parallel to the X direction.

In some examples, as shown in Fig. 7A and Fig. 7B, the display substrate further includes a second isolation structure 400, the second isolation structure 400 is stacked with the first isolation structure 300. A projection of the second isolation structure 400 on the base substrate 01 overlaps with the projection of the part of the edge of the groove 210 on the base substrate 01, and the second isolation structure protrudes into the groove opening 211 to form a second protrusion 410. The second protrusion 410 overlaps with the first protrusion 310 in the direction perpendicular to the base substrate 01. For example, the second protrusion 410 completely overlaps with the first protrusion 310. By disposing the second isolation structure 400, the protrusion can be jointly formed by the second protrusion 410 and the first protrusion 310, the strength of the protrusion can be improved by increasing the thickness of the protrusion.

In some examples, as shown in Fig. 7A and Fig. 7B, the minimum size L2 of the second isolation structure 400 along the arrangement direction of the adjacent sub-pixels 100 is not greater than the minimum size L1 of the first isolation structure 300 along the arrangement direction of the adjacent sub-pixels 100, to prevent corroding the second isolation structure 400 when the first isolation structure 300 is etched. For example, in the X direction, the size of the second isolation structure may be equal to the size of the first isolation structure. For example, in the X direction, the size of the second isolation structure 400 may be less than the size of the first isolation structure 300.

In some examples, as shown in Fig. 7B, a size H2 of the second isolation structure 400 in the direction perpendicular to the base substrate 01 may be 10 angstroms to 2000 angstroms. For example, the size of the second isolation structure 400 in the direction perpendicular to the base substrate 01 is a thickness H2. For example, the average thickness, the maximum thickness, or the minimum thickness may be H2. For example, the thickness H2 of the second isolation structure 400 may be 100 angstroms to 1500 angstroms. For example, the thickness H2 of the second isolation structure 400 may be 500 angstroms to 1000 angstroms. For example, the thickness H2 of the second isolation structure 400 may be 700 angstroms to 800 angstroms. For example, by setting the thickness of the second isolation structure 400, strength of the protrusion can be improved, and the pixel defining portion 530 can also remain flat.

For example, with reference to Fig. 7A and Fig. 7B, an edge of a light emitting region of at least one sub-pixel 100 may be arc-shaped, the second isolation structures 400 may be provided in a plurality, and the plurality of second isolation structures 400 are distributed at intervals in the circumferential direction of the at least one sub-pixel 100. For example, the plurality of second isolation structures 400 are in a one-to-one correspondence with the plurality of first isolation structures 300. For example, with reference to Fig. 7A, an edge of the second isolation structure 400 close to the second opening 520 coincides with an edge of the first isolation structure 300 close to the second opening 520. For example, with reference to Fig. 7A and Fig. 7B, a curvature of an edge of the second isolation structure 400 close to the sub-pixel 100 may be the same as a curvature of an edge of the first isolation structure 300 close to the sub-pixel. For example, curvatures of edges on two sides of the second isolation structure 400 in the X direction may be the same. For example, the shape of the first isolation structure 300 in Fig. 7A may be the same as the shape of the first isolation structure 300 in Fig. 3A. For example, a position relationship between the first isolation structure 300 and the sub-pixel 100 in Fig. 7A may be the same as a position relationship between the first isolation structure 300 and the sub-pixel 100 in Fig. 3A.

For example, with reference to Fig. 7A and Fig. 4A, both sides of the groove 520 may be provided with second isolation structures. With reference to Fig. 4A, when two sides of the groove 520 are respectively provided with a first isolation structure 300, a second isolation structure may be provided at a position corresponding to the first isolation structure 300. For example, the second isolation structure 400 shown in Fig. 7A may be applied to the display substrate shown in Fig. 4A.

For example, with reference to Fig. 7A and Fig. 7B, in the X direction, a distance between the edge of the second isolation structure 400 and an edge of a light emitting region of at least one blue sub-pixel that face each other is a fourth distance M4, a distance between the edge of the second isolation structure 400 and an edge of a light emitting region of at least one green sub-pixel that face each other is a fifth distance M5, a distance between the edge of the second isolation structure 400 and an edge of a light emitting region of at least one red sub-pixel that face each other is a sixth distance M6, the fourth distance M4 is greater than the fifth distance M5, and the fourth distance M4 is greater than the sixth distance M6, so as to reduce a drive voltage of the blue sub-pixel. Certainly, embodiments of the present disclosure are not limited to the above-mentioned X direction. The shortest distance between the edge of the second isolation structure surrounding the blue sub-pixel and the edge of the light emitting region of the blue sub-pixel may be the fourth distance, the shortest distance between the edge of the second isolation structure surrounding the green sub-pixel and the edge of the light emitting region of the green sub-pixel may be the fifth distance, and the shortest distance between the edge of the second isolation structure surrounding the red sub-pixel and the edge of the light emitting region of the red sub-pixel may be the sixth distance.

For example, with reference to Fig. 7A and Fig. 7B, a difference between the minimum distance and the maximum distance between the edges facing each other between the second isolation structure 400 and the light emitting region of the at least one blue sub-pixel is a fourth difference. For example, the minimum distance between the edge of the second isolation structure 400 and the edge of the light emitting region of the blue sub-pixel facing each other may be N3, the maximum distance between the edge of the second isolation structure 400 and the edge of the light emitting region of the blue sub-pixel facing each other may be N4, and the fourth difference is a difference between N3 and N4. A difference between the minimum distance and the maximum distance between the edges facing each other between the second isolation structure 400 and the light emitting region of the at least one green sub-pixel is a fifth difference, a difference between the minimum distance and the maximum distance between the edges facing each other between second isolation structure 400 and the light emitting region of the at least one red sub-pixel is a sixth difference, the fourth difference is greater than the fifth difference, and the fourth difference is greater than the sixth difference.

For example, the edge of the second isolation structure 400 and the edge of the light emitting region of the blue sub-pixel may be bent toward opposite directions, so as to increase the distance between the second isolation structure 400 and the blue sub-pixel. For example, the edge of the second isolation structure and the edge of the light emitting region of the blue sub-pixel may be bent toward a same direction, and the curvature of the edge of the second isolation structure is greater than the curvature of the edge of the light emitting region of the blue sub-pixel. For example, the edge of the second isolation structure 400 and the edge of the light emitting region of the green sub-pixel that face each other may be bent toward a same direction. For example, the edge of the second isolation structure 400 and the edge of the light emitting region of the red sub-pixel that face each other may be bent toward a same direction. For example, the shape of the edge of the second isolation structure 400 separately matches the shape of the edge of the light emitting region of the red sub-pixel and the shape of the edge of the light emitting region of the green sub-pixel.

For example, with reference to Fig. 7A and Fig. 7B, a ratio of an outer contour perimeter of the second isolation structure 400 to an outer contour perimeter of the light emitting region of at least one blue sub-pixel is a fourth ratio, a ratio of an outer contour perimeter of the second isolation structure 400 to an outer contour perimeter of the light emitting region of at least one green sub-pixel is a fifth ratio, a ratio of an outer contour perimeter of the second isolation structure 400 to an outer contour perimeter of the light emitting region of at least one red sub-pixel is a sixth ratio, the fourth ratio is greater than the fifth ratio, and the fourth ratio is greater than the sixth ratio.

In some examples, as shown in Fig. 7A and Fig. 7B, the second isolation structure 400 includes at least one selected from the group consisting of the conductive material and the insulation material. For example, the second isolation structure 400 includes at least one selected from the group consisting of a metal material, an oxide semiconductor material, an organic insulation material, and an inorganic insulation material. For example, the material of the second isolation structure 400 may be the same as the material of the first isolation structure 300, or may be different from the material of the first isolation structure 300.

For example, as shown in Fig. 7B, the first isolation structure 300 may be formed with the first electrode 110 by the same step patterning process. For example, a material layer is formed on the insulating layer 200, and the material layer may be patterned to form the first isolation structure 300 and the first electrode 110 at the same time. For example, the first electrode 110 and the first isolation structure 300 may be both single-layer structures, and materials of the first isolation structure 300 and the first electrode 110 are the same. For example, the first electrode 110 may use a metal material, for example, any one or more selected from the group consisting of magnesium (Mg), silver (Ag), copper (Cu), aluminum (Al), titanium (Ti), and molybdenum (Mo), or an alloy material of the above-mentioned metals, for example, an aluminum neodymium alloy (AlNd) or a molybdenum niobium alloy (MoNb).

For example, as shown in Fig. 7B in combination with Fig. 3D, the first electrode 110 may be a multi-layer composite structure, such as ITO/Ag/ITO, the first isolation structure 300 may be a single-layer structure, and a material of the first isolation structure 300 may be the same as a material of one film layer of the first electrode 110. For example, the material of the first electrode 110 is ITO/Ag/ITO, and the material of the first isolation structure 300 is ITO. For example, the first isolation structure 300 may be separately manufactured, that is, the first isolation structure 300 and the first electrode 110 are respectively formed in different processes. For example, when the material of the first isolation structure 300 is a single-layer ITO, the first isolation structure 300 made of the ITO material may be protected in the manufacturing process, to prevent corroding the first isolation structure 300 when the first electrode 110 is etched. For example, the first electrode 110 may be a multi-layer composite structure, such as Ti/Al/Ti, or a laminated structure formed by metal and a transparent conductive material, such as a reflective material made of ITO/Ag/ITO, Mo/AlNd/ITO, etc. For example, the first isolation structure 300 may be a multi-layer composite structure the same as the first electrode 110, for example, Ti/Al/Ti, ITO/Ag/ITO, or Mo/AlNd/ITO.

In some examples, as shown in Fig. 7B, the first electrode 110 includes a plurality of electrode layers (with reference to Fig. 3D), the second isolation structure 400 is made of the same material as at least one of the electrode layers of the first electrode 110. In some examples, the second isolation structure 400 includes at least one film layer. For example, the first isolation structure 300 and the first electrode 110 are both multi-layer composite structures, and the second isolation structure 400 may be a single-layer structure. For example, materials of the first isolation structure 300 and the first electrode 110 are both ITO/Ag/ITO, and a material of the second isolation structure 400 may be ITO. For example, materials of the first isolation structure 300 and the first electrode 110 are both Ti/Al/Ti, and a material of the second isolation structure 400 may be Ti. For example, materials of the first isolation structure 300 and the first electrode 110 are both ITO/Ag/ITO, and by additionally adding a coating process and an etching process, the material of the second isolation structure 400 may be Ti.

For example, as shown in Fig. 7B, the first isolation structure 300 and the first electrode 110 are both multi-layer composite structures, and the second isolation structure 400 may be a multi-layer composite structure. For example, the second isolation structure 400 of the multi-layer composite structure may have the same structure as the first isolation structure 300 of the multi-layer composite structure shown in Fig. 3D. For example, materials of the first isolation structure 300 and the first electrode 110 are both ITO/Ag/ITO, and a material of the second isolation structure 400 may be ITO/Ag/ITO. For example, materials of the first isolation structure 300 and the first electrode 110 are both Ti/Al/Ti, and a material of the second isolation structure 400 may be Ti/Al/Ti.

With reference to Fig. 7B, by taking an example in which materials of the first electrode 110 and the first isolation structure 300 are ITO/Ag/ITO, and the material of the second isolation structure 400 is ITO, sizes (thicknesses) of the ITO layer in the first electrode 110 and the ITO layer in the first isolation structure 300 in the direction perpendicular to the base substrate 01 may be 10 angstroms to 2000 angstroms, the size (thickness) of the Ag layer in the direction perpendicular to the base substrate 01 may be 400 angstroms to 2000 angstroms, and the thickness H2 of the second isolation structure 400 may be 10 angstroms to 2000 angstroms.

Fig. 8A and Fig. 8B are schematic flowcharts of a manufacturing method of a display substrate before the formation of the structure shown in Fig. 7B provided by an example in at least one embodiment of the present disclosure.

With reference to Fig. 8A and Fig. 8B in combination with Fig. 7B, at least one embodiment of the present disclosure provides a manufacturing method of a display substrate. The manufacturing method includes: forming a plurality of sub-pixels 100 on a base substrate 01, forming the sub-pixels 100 includes sequentially forming a first electrode 110, a light emitting functional layer (not shown in the figure), and a second electrode (not shown in the figure) that are stacked in a direction perpendicular to the base substrate 01, and the first electrode 110 is located between the light emitting functional layer and the base substrate 01; forming an insulation material layer on the base substrate 01; forming an isolation material layer on the insulation material layer, and patterning the isolation material layer to form a second isolation structure 400; and forming a conductive material layer on a side of the insulation material layer that is away from the base substrate 01. The conductive material layer is patterned to form the first electrode 110 and the first insulation structure 300, and there is a gap 101 between the first electrode 110 and the first isolation structure 300. Etching the insulation material layer to form the groove 210. A projection of the first isolation structure 300 on the base substrate 01 overlaps with a projection of a part, which forms an edge of the groove 210, in a surface of the insulation material layer away from the base substrate 01 on the base substrate, and the first isolation structure 300 protrudes into the groove opening 211 to form the first protrusion 310. A projection of the second isolation structure 400 on the base substrate 01 overlaps with a projection of a part, which forms an edge of the groove 210, in a surface of the insulation material layer away from the base substrate 01, and the second isolation structure 400 protrudes into the groove opening 211 to form the second protrusion 410. The second protrusion 410 overlaps with the first protrusion 310 in the direction perpendicular to the base substrate 01. The light emitting functional layer is formed after the groove 210 is formed. The light emitting functional layer includes a plurality of film layers, and at least one film layer among the plurality of film layers is disconnected at the first protrusion 310. By forming the isolation material layer on the insulation material layer and patterning the isolation material layer to form the second isolation structure 400, the protrusion can be jointly formed by the second protrusion 410 and the first protrusion 310, the strength of the protrusion can be improved by increasing the thickness of the protrusion.

For example, with reference to the manufacturing method in Fig. 5A to Fig. 5E, in the display substrate shown in Fig. 7B, the groove 210 may also be formed first through etching, and then the pixel defining pattern 500 is manufactured, to simplify the coating process of the photoresist. For example, with reference to the manufacturing method of Fig. 6A and Fig. 6B, in the display substrate shown in Fig. 7B, the groove 210 may also be formed through etching after the pixel defining pattern 500 is manufactured, to prevent the photoresist from remaining on a side of the second protrusion 410 faces the groove 210.

For example, with reference to Fig. 7A to Fig. 8B, the second isolation structure 400 may be located between the first isolation structure 300 and the insulating layer 200. To be specific, in the manufacturing process, the second isolation structure 400 may be first manufactured, and then the first electrode 110 and the first isolation structure 300 are manufactured. For example, the first isolation structure may be located between the second isolation structure and the insulating layer. To be specific, in the manufacturing process, the first electrode and the first isolation structure may be first manufactured, and then the second isolation structure is manufactured. For example, the material of the first isolation structure is the same as the material of one layer in the first electrode, the possible influence of different materials in different manufacturing processes may be ignored, simplifying the process.

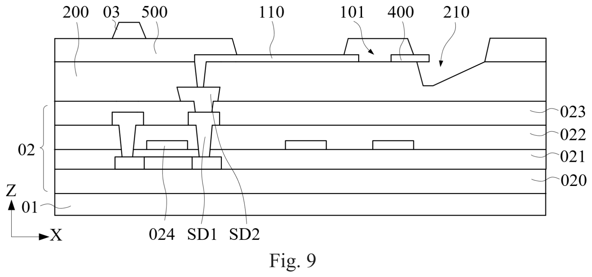

Fig. 9 is a partial cross-sectional schematic view of a display substrate provided by an example in at least one embodiment of the present disclosure.

As shown in Fig. 9, for example, the material of the second isolation structure 400 may be different from the material of the first electrode 110. For example, the thickness of the second isolation structure 400 may be set to be relatively large, to replace the first isolation structure. For example, the material of the second isolation structure may be an inorganic insulation material. For example, a passivation layer 023 may be further included between the insulating layer 200 and the base substrate 01, and the material of the second isolation structure 400 may be the same as the material of the passivation layer 023. For example, the material of the first isolation structure may be further set to be different from the material of the first electrode. In this case, the position of the first isolation structure may refer to the position of the second isolation structure 400 shown in Fig. 9.

For example, as shown in Fig. 1 to Fig. 9, other film layer 02 is disposed between the insulating layer 200 and the base substrate 01. The other film layer 02 may include a gate insulating layer 021, an interlayer insulating layer 022, a passivation layer 023, a film layer where a gate is located 024, a data line, film layers in a pixel circuit (for example, including structures such as a thin film transistor and a storage capacitor), and film layers or structures such as a power supply signal line, a reset power supply signal line, a reset control signal line, and a light emitting control signal line. For example, the other film layer 02 may further include an intermediate film layer 020 located between the base substrate 01 and the gate insulating layer 021. For example, the intermediate film layer 020 may be a film layer such as a buffer layer. For example, with reference to Fig. 8A, the other film layer 02 may include one metal layer: an SD layer (that is, a film layer where a data line and a power supply signal line are located). For example, with reference to Fig. 9, the other film layer 02 may include two metal layers: an SD1 layer and an SD2 layer (for example, the other film layer 02 may include two layers of power supply signal lines, and the two layers of power supply signal lines may be electrically connected to each other). For example, a surface of the insulating layer 200 faces the base substrate 01 may be in contact with a passivation layer 023.

For example, as shown in Fig. 1 to Fig. 9, the first electrode 110 of an organic light emitting element may be connected to one of a source and a drain of a thin film transistor in a pixel circuit through a via running through the insulating layer 200 and the other film layer 02.

For example, as shown in Fig. 9, a spacer 03 is further disposed on the pixel defining portion 530 of the pixel defining pattern 500, to support an evaporation mask plate for manufacturing a light emitting layer.

At least one embodiment of the present disclosure provides a display device, including the display substrate according to any one of the above-mentioned embodiments. Because the display device according to embodiments of the present disclosure includes the above-mentioned display substrate, the display device also has the corresponding beneficial technical effect, and details are not described herein again.

The following statements should be noted:
(1) The accompanying drawings involve only the structure(s) in connection with the embodiment(s) of the present disclosure, and other structure(s) can be referred to common design(s).
(2) In case of no conflict, features in one embodiment or in different embodiments can be combined.

What have been described above are only specific implementations of the present disclosure, the protection scope of the present disclosure is not limited thereto. The protection scope of the present disclosure should be based on the protection scope of the claims.

## Claims

1. A display substrate, comprising:
a base substrate;
a plurality of sub-pixels, located on the base substrate, wherein each sub-pixel in at least part of the plurality of sub-pixels comprises a light emitting functional layer and a first electrode and a second electrode that are located on two sides of the light emitting functional layer along a direction perpendicular to the base substrate, the first electrode is located between the light emitting functional layer and the base substrate; the light emitting functional layer comprises a plurality of film layers; and
an insulating layer, located between the first electrode and the base substrate;
wherein the display substrate further comprises a first isolation structure, located on a side of the insulating layer that is away from the base substrate, and an orthographic projection of the first isolation structure on the base substrate overlaps with an orthographic projection of the insulating layer on the base substrate;
the insulating layer comprises a groove, the groove and the first isolation structure are at least partially located between adjacent sub-pixels, a projection of the first isolation structure on the base substrate overlaps with a projection of a part, which forms an edge of the groove, of a surface of the insulating layer away from the base substrate on the base substrate, and the first isolation structure protrudes into a groove opening of the groove to form a first protrusion;
at least part of the first electrode and at least part of the first isolation structure are made of a same material and are arranged in a same layer, and there is a gap between the first electrode and the first isolation structure; and
at least one film layer among the plurality of film layers is disconnected at the first protrusion.

2. The display substrate according to claim 1, further comprising a second isolation structure, stacked with the first isolation structure; wherein a projection of the second isolation structure on the base substrate overlaps with the projection of the part of the edge of the groove on the base substrate, and the second isolation structure protrudes into the groove opening to form a second protrusion; and the second protrusion overlaps with the first protrusion in the direction perpendicular to the base substrate.

3. The display substrate according to claim 2, wherein a minimum size of the second isolation structure along an arrangement direction of the adjacent sub-pixels is not greater than a minimum size of the first isolation structure along the arrangement direction of the adjacent sub-pixels.

4. The display substrate according to claim 2 or 3, wherein a size of the second isolation structure in the direction perpendicular to the base substrate is 10 angstroms to 2000 angstroms.

5. The display substrate according to any one of claims 2 to 4, wherein the second isolation structure comprises at least one selected from the group consisting of a conductive material and an insulation material.

6. The display substrate according to claim 5, wherein the first electrode comprises a plurality of electrode layers, the second isolation structure is made of the same material as at least one electrode layer of the first electrode, and the second isolation structure is located between the first isolation structure and the insulating layer.

7. The display substrate according to any one of claims 2 to 6, wherein the second isolation structure comprises at least one film layer.

8. The display substrate according to any one of claims 1 to 7, wherein a minimum distance between the first electrode and the first isolation structure in an arrangement direction of the adjacent sub-pixels is not less than 1 micron, and a ratio of the minimum distance to a size of the sub-pixel in the arrangement direction of the adjacent sub-pixels is not greater than 2.

9. The display substrate according to any one of claims 1 to 8, wherein a ratio of a size of the first electrode in the direction perpendicular to the base substrate to a size of the first isolation structure in the direction perpendicular to the base substrate is 0.9 to 1.1.

10. The display substrate according to any one of claims 1 to 9, wherein, in an arrangement direction of the adjacent sub-pixels, a ratio of a minimum size of the first protrusion to a minimum size of the first isolation structure is 0.005 to 0.2.

11. The display substrate according to any one of claims 1 to 10, wherein the groove comprises a first side wall and a second side wall that are disposed opposite to each other in an arrangement direction of the adjacent sub-pixels, and in the direction perpendicular to the base substrate, at least the first side wall overlaps with the first isolation structure;
a slope angle between the first side wall and a plane parallel to a contact surface of the first side wall and the first isolation structure is a first slope angle;
a slope angle between the second side wall and the plane parallel to the contact surface of the first side wall and the first isolation structure is a second slope angle; and
the first slope angle is not greater than the second slope angle.

12. The display substrate according to claim 11, wherein the first slope angle is less than the second slope angle, and an angle of the first slope angle is 60° to 150°.

13. The display substrate according to claim 11 or 12, further comprising:
a pixel defining pattern, located on a side of the first electrode that is away from the base substrate, wherein the pixel defining pattern comprises a plurality of first openings, one sub-pixel corresponds to at least one first opening, and the light emitting functional layer of the sub-pixel is at least partially located in the first opening corresponding to the sub-pixel, and the first opening is configured to expose the first electrode;
wherein the pixel defining pattern further comprises a plurality of second openings, and the first protrusion is exposed by the second opening.

14. The display substrate according to claim 13, wherein the pixel defining pattern comprises a pixel defining portion surrounding the plurality of first openings and the plurality of second openings, and a slope angle between at least part of a side surface of the pixel defining portion and a plane parallel to a contact surface of the pixel defining portion and the first isolation structure is a third slope angle;
the third slope angle is not greater than the first slope angle.

15. The display substrate according to claim 13 or 14, wherein a ratio of a minimum size of the second opening along the arrangement direction of the adjacent sub-pixels to a minimum size of the first opening along the arrangement direction of the adjacent sub-pixels is 0.05 to 2.

16. The display substrate according to any one of claims 13 to 15, wherein the pixel defining portion covers the gap.

17. The display substrate according to any one of claims 13 to 16, wherein there is an overlapping portion between an orthographic projection of the pixel defining portion on the base substrate and an orthographic projection of the first electrode on the base substrate; and
a minimum size of the overlapping portion along the arrangement direction of the adjacent sub-pixels is not less than 0.5 microns.

18. The display substrate according to any one of claims 13 to 17, wherein a ratio of a size of the groove opening along the arrangement direction of the adjacent sub-pixels to a size of the second opening along the arrangement direction of the adjacent sub-pixels is 0.7 to 1.5.

19. The display substrate according to any one of claims 1 to 18, wherein, in the direction perpendicular to the base substrate, a maximum size of the groove is not greater than a maximum size of the insulating layer, and a size of the groove in the direction perpendicular to the base substrate is not less than 0.1 micron.

20. A display device, comprising the display substrate according to any one of claims 1 to 19.

21. A manufacturing method of a display substrate, comprising:
forming a plurality of sub-pixels on a base substrate, wherein forming the sub-pixels comprises sequentially forming a first electrode, a light emitting functional layer, and a second electrode that are stacked in a direction perpendicular to the base substrate, and the first electrode is located between the light emitting functional layer and the base substrate; and
the manufacturing method further comprises:
forming an insulation material layer on the base substrate; and
forming a conductive material layer on a side of the insulation material layer that is away from the base substrate,
wherein the conductive material layer is patterned to form the first electrode and an isolation structure, and there is a gap between the first electrode and the isolation structure;
etching the insulation material layer to form a groove, wherein a projection of the isolation structure on the base substrate overlaps with a projection of a part, which forms an edge of the groove, of a surface of the insulating layer away from the base substrate on the base substrate, and the isolation structure protrudes into a groove opening of the groove to form a protrusion; and
the light emitting functional layer is formed after the groove is formed, the light emitting functional layer comprises a plurality of film layers, and at least one film layer among the plurality of film layers is disconnected at the protrusion.
